# EUROPÄISCHE PATENTSCHRIFT

(11) **EP 2 952 988 B1**
(45) Veröffentlichungstag und Bekanntmachung des Hinweises auf die Patenterteilung: **29.07.2020**
(21) Anmeldenummer: 14170951.9
(22) Anmeldetag: 03.06.2014
(51) Int. Cl.: G05B 19/4069

(54) **Verfahren zur Berechnung einer optimierten Trajektorie**
Method for calculating an optimised trajectory
Procédé de calcul d'une trajectoire optimisée

(43) Veröffentlichungstag der Anmeldung: 09.12.2015
(73) Patentinhaber: Siemens Aktiengesellschaft, 80333 München (DE)
(72) Erfinder: Lorenz, Ulrich Wolfgang, 10709 Berlin (DE); Schäufele, Stephan, 91052 Erlangen (DE)

(56) Entgegenhaltungen:
- EP-A1- 2 254 013
- WO-A1-2014/063262
- DE-A1-102005 024 822
- DE-B3-102012 112 172

## Beschreibung

Die Erfindung betrifft ein Verfahren zur Berechnung einer optimierten Trajektorie eines Bauteils. Weiter betrifft die Erfindung ein Computerprogrammprodukt zur Durchführung eines solchen Verfahrens. Zudem betrifft die Erfindung eine Steuerungseinrichtung, die ein solches Verfahren durchführt, sowie eine Produktionsmaschine, insbesondere eine Presse, mit einer solchen Steuerungseinrichtung.

Pressen werden in der industriellen Fertigung mannigfach zur Bearbeitung von Bauteilen, insbesondere von Blechen, beispielsweise zur Herstellung von Karosserieteilen in der Automobilindustrie, eingesetzt. Produktionsmaschinen, insbesondere Pressen, werden meist automatisiert bestückt. Die Bestückung der Produktionsmaschine mit einem Bauteil erfolgt durch eine Halterung, wobei die Halterung das Bauteil aufnimmt und in die Produktionsmaschine einbringt. Dieselbe Halterung oder eine weitere Halterung nimmt nach dem Durchlauf des Produktionsverfahrens in der Produktionsmaschine das Bauteil wieder heraus.

Insbesondere bei Pressen ergibt sich das Problem beim automatisierten Einbringen des Bauteils mittels einer Halterung, dass das Bauteil nur in einem engen Bereich in die Presse eingebracht werden kann. Um eine Kollision des Bauteils mit der Presse, insbesondere den Presswerkzeugen, zu verhindern, ist eine geeignete Bahnkurve erforderlich. Eine solche Bahnkurve muss vor der Bestückung der Presse mit dem Bauteil regelmäßig manuell erstellt werden. Dazu werden Geometrieparameter der Presse und ggf. weitere Parameter als Randbedingungen zur Berechnung einer Bahnkurve mittels eines Simulationsprogramms eingesetzt. Um eine simulierte Bahnkurve zu verbessern, wurde die Bahnkurve durch qualifiziertes Personal verändert. Eine Verbesserung der Bahnkurve ist jedoch mühsam und bedarf erfahrenes und qualifiziertes Personal.

Aus der PCT-Offenlegungsschrift WO 2014/063262 A1 ist es bekannt, eine Werkstücktrajektorie für eine Mehr-Stationen Presse zu berechnen mit Hilfe von einer Frage kommenden Werkstücktrajektorie und einer Simualation.

In der Offenlegungsschrift DE 10 2005 024822 A1 ist ein Verfahren zur Optimierung der Transportbewegung von Werkstücken in Transferpressen beschrieben, bei dem durch Manipulation einer Bewegungskurve in einem digitalen Abbild der Transferpresse Rückschlüsse auf Freigängigkeiten, Hubzahlen und Programmdaten für werkzeugspezifische Maschinensteuerung gezogen werden können.

Aufgabe der Erfindung ist es daher, ein Verfahren zur automatisierten Optimierung der Berechnung einer Bahnkurve oder Trajektorie bereitzustellen.

Die Aufgabe wird mittels eines Verfahrens zur Berechnung einer optimierten Trajektorie mindestens eines Bauteils und/ oder einer Halterung für das Bauteil für einen Transport des Bauteils in eine Produktionsmaschine hinein und/oder aus der Produktionsmaschine heraus, gelöst, wobei mindestens eine Optimierungsroutine einem Simulationsprogramm zugeordnet ist, wobei das Simulationsprogramm das Einbringen und/oder die Entnahme des Bauteils aus der Produktionsmaschine simuliert, wobei mit dem Simulationsprogramm anhand von Randbedingungen eine erste Trajektorie berechnet wird, in der Optimierungsroutine aus der ersten Trajektorie ein Parameter, insbesondere eine Geschwindigkeit, berechnet wird, wobei mittels der Optimierungsroutine ein veränderter Parameter ermittelt wird und eine weitere Trajektorie anhand dem veränderten Parameter erzeugt wird, wobei die weitere Trajektorie in einer Schleife verändert wird, wobei die Schleife zumindest folgende aufweist:
- wobei in einem ersten Schritt mittels des Simulationsprogramms die weitere Trajektorie an die Randbedingungen angepasst wird und der Optimierungsroutine zugewiesen wird, wobei in einem zweiten Schritt auf Grundlage der weiteren Trajektorie der Parameter ermittelt wird,
- wobei in einem dritten Schritt auf Grundlage des Parameters der veränderten Parameter ermittelt wird,
- wobei in einem vierten Schritt auf Grundlage des veränderten Parameters die weitere Trajektorie berechnet wird und die weitere Trajektorie dem Simulationsprogramm zugewiesen wird,
wobei die Schleife so lange durchlaufen wird, bis der veränderte Parameter einen vorgegebenen Wert oder einen extremalen Wert erreicht, wobei die optimale Trajektorie aus dem extremalen Wert oder dem vorgegebenen Wert berechnet und mit dem Simulationsprogramm an die Randbedingungen angepasst wird.

Die Aufgabe wird weiter mit einem Computerprogrammprodukt gemäß Anspruch 9 gelöst.

Die Aufgabe wird weiter durch eine Steuerungseinrichtung gemäß Anspruch 11 gelöst.

Die Aufgabe wird weiter durch eine Produktionsmaschine, insbesondere eine Presse, vorzugweise eine Servopresse, gemäß Anspruch 12 gelöst, wobei die Produktionsmaschine eine Steuerung gemäß Anspruch 11 aufweist.

Unter einer Produktionsmaschine versteht man eine Presse, insbesondere eine Servopresse, eine Crimpvorrichtung, eine Bearbeitungsmaschine und/oder eine Verpackungsmaschine. Die Erfindung kann auch in einer Werkzeugmaschine angewandt werden. Vorteilhaft ist einer solchen Produktionsmaschine eine Beförderungseinrichtung zugeordnet.

Unter einem Bauteil versteht man insbesondere ein Blech, ein Werkstück, ein Halbzeug, ein Kunststoffteil oder ein noch nicht fertiges Produkt, das einer Produktionsmaschine zugeführt wird, um dessen Eigenschaften zu verändern. Ein Bauteil kann insbesondere ein, vorzugsweise noch umzuformendes, Karosserieteil, beispielsweise eines Kraftfahrzeugs, sein. Nach der Veränderung der Eigenschaften, vorzugsweise der Form des Bauteils, wird das Bauteil wieder aus der Produktionsmaschine entfernt. Zur Bestückung und/oder zur Entnahme des Bauteils ist die Beförderungseinrichtung vorgesehen.

Unter einer Trajektorie versteht man einen räumlichen Verlauf einer Halterung und/oder eines Bauteils, insbesondere in die Produktionsmaschine hinein oder aus der Produktionsmaschine hinaus. Die Trajektorie beschreibt weiter die räumliche Ausrichtung des Bauteils und/oder die räumliche Ausrichtung der Halterung. Es ist auch möglich, mittels einer Halterung mehrere Bauteile zu transportieren und somit in die Produktionsmaschine einzubringen oder aus der Produktionsmaschine wieder zu entfernen.

Eine Trajektorie ist eine Raumkurve, wobei einzelne Punkte der Raumkurve mit weiteren Größen verknüpft sind, wobei die Raumkurve vorteilhaft in einer Datei ablegbar und speicherbar ist, wobei die Raumpunkte die Orte der Halterung und/oder des Bauteils, Ausrichtung der Halterung und/oder des Bauteils aufweisen. Die weiteren Größen sind z.B. die Zeitpunkte und/ oder Geschwindigkeiten, die den einzelnen Punkten der Raumkurve zugeordnet sind.

Eine Trajektorie ist vorteilhaft durch diskrete Punkte, denen ggf. die weiteren Größen zugeordnet sind, oder durch Koeffizienten einer Funktion, insbesondere Entwicklungskoeffizienten einer Reihendarstellung einer Funktion, darstellbar und/ oder speicherbar. Entwicklungskoeffizienten sind Koeffizienten, die sich aus einer vorher definierten Reihendarstellung der Trajektorie, beispielsweise einer Taylor-Reihe, einer Laurent-Reihe oder einer Fourier-Reihe der Trajektorie, ergeben. Mit dem Begriff "Trajektorie" wird im Folgenden eine erste Trajektorie, eine weitere Trajektorie oder eine optimierte Trajektorie bezeichnet.

Unter einer ersten Trajektorie versteht man eine Trajektorie, die ohne eine Simulation oder in einer ersten Simulation mit dem Simulationsprogramm erstellt worden ist. Die erste Trajektorie wird insbesondere mittels einem, dafür geeigneten Computerprogramm, wie einem CAD Programm, an Randbedingungen angepasst. Vorteilhaft ist eine erste Trajektorie beispielsweise manuell erzeugt und/oder mittels eines Simulationsprogrammes an Randbedingungen angepasst. Die erste Trajektorie wird beispielsweise derart erstellt, dass ein Bauteil gerade nicht an den Rändern der Produktionsmaschine anstößt, ggf. mit einer geringen Änderung der Ausrichtung in eine Produktionsmaschine eingeführt wird und/oder mit einer geringen Geschwindigkeit in die Produktionsmaschine eingebracht wird oder aus der Produktionsmaschine entnommen wird.

Eine weitere Trajektorie ist eine Trajektorie, welche mit Hilfe einer Optimierungsroutine und/oder mit Hilfe eines Simulationsprogramms verändert worden ist. Einer weiteren Trajektorie ist ein veränderter Parameter zuordenbar. Eine weitere Trajektorie geht aus einer ersten Trajektorie oder einer weiteren Trajektorie durch eine Veränderung hervor.

Unter einer optimierten Trajektorie versteht man eine Trajektorie, welche aus einem extremalen Parameter, beispielsweise einer maximal erreichbaren Geschwindigkeit oder einer maximal erreichbaren Hubzahl, erzeugt worden ist und ggf. an die Randbedingungen angepasst worden ist. Eine optimierte Trajektorie geht meist aus einer weiteren Trajektorie hervor, welche zumindest einmal verändert/optimiert worden ist. Die Anpassung an die Randbedingungen erfolgt mit Hilfe des Simulationsprogramms. Eine optimierte Trajektorie zeichnet beispielsweise aus, dass entlang der extremalen Trajektorie das Bauteil besonders schnell in die Produktionsmaschine eingelegt und/oder aus der Produktionsmaschine entnommen werden kann.

Eine optimierte Trajektorie kann auch auszeichnen, dass die Zeit, die für die Zuführung des Bauteils in die Produktionsmaschine und/oder zur Entnahme des Bauteils aus der Produktionsmaschine und/oder zur Überführung des Bauteils an einen anderen Ort minimal ist.

Eine optimierte Trajektorie kann auch auszeichnen, dass die Zeitdauer, die für die Zuführung des Bauteils in die Produktionsmaschine und/oder zur Entnahme des Bauteils aus der Produktionsmaschine und/oder zur Überführung des Bauteils an einen anderen Ort gerade der Zeitdauer entspricht, welche die Produktionsmaschine für einen Zyklus bei einer maximalen Betriebsgeschwindigkeit benötigt.

Die Form einer optimierten Trajektorie hängt ggf. von der Geschwindigkeit ab, mit der das Bauteil und/oder die Halterung die Trajektorie durchläuft. Das Bauteil ist hierbei an der Halterung befestigt. Die Form der Trajektorie und/oder der vorteilhaften Ausrichtung des Bauteils und/oder der Halterung kann sich deshalb ändern, da Belastungen auf das Bauteil und/ oder die Halterung aufgrund von Beschleunigung derselben die Form und/oder die Position des Bauteils und/oder der Halterung durch Krafteinwirkung verändern.

Randbedingungen orientieren sich an den Ausmaßen und Größen der Produktionsmaschine, des Bauteils und/oder der Halterung, sowie ggf. einzuhaltenden Sicherheitsabständen von dem Bauteil zur Oberfläche der Produktionsmaschine. Randbedingungen können als Bereiche im Raum formuliert sein, in die das Bauteil nicht eindringen darf. Randbedingungen können auch Bereiche sein, in denen die erste Trajektorie, die weiteren Trajektorien sowie die optimierte Trajektorie verändert werden können. Gemäß dem hier beschriebenen Beispiel sind beispielsweise die Randbedingungen als maximale und minimale Parameter formuliert, zwischen denen sich die (veränderten) Parameter bewegen dürfen. Dabei bestehen ggf. Abhängigkeiten der maximalen und der minimalen Werte der (veränderten) Parameter mit Werten weiterer (veränderter) Parameter. Die Trajektorien verlaufen dann vorteilhaft in Bereichen, welche durch die minimalen und/oder maximalen Werte der (veränderten) Parameter definiert sind.

Falls die Werkzeuge der Produktionsmaschine sich während des Einbringens des Bauteils in die Produktionsmaschine oder der Entnahme des Bauteils aus der Produktionsmaschine bewegt, sind die Randbedingungen von der Zeit abhängig.

Falls beispielsweise ein Presswerkzeug einer Presse eine periodische Bewegung durchführt, und diese nicht während des Einbringens des Bauteils in die Presse und/oder der Entnahme des Bauteils aus der Presse gestoppt wird, so weist die Randbedingung eine periodische Zeitabhängigkeit auf.

Randbedingungen können auch maximale Drehzahlen von Motoren, maximale Hubzahlen der Presse, maximale Beschleunigungen des Bauteils und/oder der Halterung, minimale Durchlaufzeiten sowie bewegungsabhängige Verformungen der Halterung und/oder des Bauteils aufweisen.

Unter einem Parameter versteht man eine optimierbare Größe, oder eine Menge von optimierbaren Größen, welche eine Eigenschaft einer oben ausgeführten Bahnkurve ist/sind. Ein Parameter kann eine Geschwindigkeit, in der eine Halterung und/ oder ein Bauteil die Trajektorie durchläuft, eine Durchlaufzeit und/oder eine Hubzahl bei einer Presse sein.

Der Parameter oder die Komponenten des Parameters sowie der veränderte Parameter oder die Komponenten des veränderten Parameters sind vorteilhaft anordenbar. Die Anzahl der Komponenten des Parameters bzw. des veränderten Parameters orientieren sich vorteilhaft an der Trajektorie und kann von Trajektorie zu Trajektorie schwanken.

Unter einem veränderten Parameter versteht man einen Parameter, der aus einer weiteren Trajektorie hervorgeht und/oder der, insbesondere durch die Optimierungsroutine, verändert wurde. Anhand eines weiteren Parameters wird eine weitere Trajektorie anhand einer geeigneten Prozedur erstellt.

Der veränderte Parameter kann eine, aus der ersten Trajektorie und/oder einer weiteren Trajektorie hervorgehende und mittels einer Berechnungsvorschrift der Optimierungsroutine hervorgehende, Zahl oder ein Zahlentupel sein.

Eine Berechnungsvorschrift ist beispielsweise ein genetischer Algorithmus, ein generischer Algorithmus, eine Berechnungsmethode, die auf einem neuronalen Netz basiert, oder auf eine Berechnungsmethode, die auf einer vorgegebenen Zahlenfolge basiert.

Der veränderte Parameter wird vorteilhaft mittels der Optimierungsroutine gemäß einer vorstehend ausgeführten Berechnungsvorschrift ermittelt.

Unter einem extremalen Wert versteht man einen Parameter, der im Vergleich mit einer Anzahl von veränderten Parametern ein Maximum, ein Minimum oder ein Optimum darstellt. Beispielsweise ist ein extremaler Wert eine maximale Geschwindigkeit oder eine maximale Hubzahl oder eine minimal erreichbare Zeitdauer.

Ein vorgegebener Wert ist demnach eine vorgegebene maximale Geschwindigkeit einer Halterung oder eine maximal ausführbare Hubzahl der Produktionsmaschine, vorzugsweise der Presse.

Eine Optimierungsroutine ist eine Berechnungsvorschrift, welche aus einer eingehenden Trajektorie, beispielsweise einer weiteren Trajektorie, eine weitere Trajektorie oder eine optimierte Trajektorie berechnet. Die, mittels der Optimierungsroutine erstellten, weitere Trajektorie wird dem Simulationsprogramm zugeführt. Eine Optimierungsroutine kann auch als Skript, beispielsweise ein Shell-Skript, verfasst sein. So muss ein vorhandenes Simulationsprogramm nicht notwendigerweise verändert werden. Eine Optimierungsroutine kann auch als eigenständiges Programm, als Skript, als Add-on und/oder vorzugsweise als Unterprogramm des Simulationsprogramms, vorliegen.

In einer vorteilhaften Ausgestaltung lädt die Optimierungsroutine von einem Speicher die erste Trajektorie oder die weitere Trajektorie ein. Aus einer ersten Trajektorie wird ein Parameter bestimmt. Aus der weiteren Trajektorie wird ein veränderter Parameter bestimmt. Mittels einer Berechnungsvorschrift wird der Parameter oder der veränderte Parameter verändert. Die Berechnungsvorschrift hat vorteilhaft als Eingangsgrößen die, ggf. in vorherigen Durchläufen bereits erstellten, Trajektorien und/oder die, schon berechneten, (veränderten) Parameter. Mit diesen Eingangsgrößen werden mittels der Berechnungsvorschrift ein (neuer) veränderter Parameter und/oder eine weitere Trajektorie berechnet. Bei der Berechnung eines veränderten Parameters kann aus dem veränderten Parameter die weitere Trajektorie erzeugt werden. Die weitere Trajektorie wird danach entweder abgespeichert und/oder dem Simulationsprogramm zugeführt.

Vorteilhaft werden mit der Optimierungsroutine mehrere weitere Trajektorien erzeugt, wobei entweder eine der weiteren Trajektorien zur Übertragung an das Simulationsprogramm ausgewählt werden oder das Simulationsprogramm eine Simulation für mehrere weitere Trajektorien durchführt und danach die weitere Trajektorie wieder an die Optimierungsroutine überträgt, die sich durch die Simulation am geeignetsten herausgestellt hat. Aus einer Mehrzahl von Trajektorien kann auch eine weitere Trajektorie ausgewählt werden, welche an das Simulationsprogramm übermittelt wird. Weiter können auch die Mehrzahl der Trajektorien mit Hilfe des Simulationsprogramms an die Randbedingungen angepasst werden und im weiteren Verlauf eine Auswahl durchgeführt werden. Ein so ausgestaltetes Verfahren wird beispielsweise bei einem genetischen Algorithmus angewandt. Am besten geeignet ist diejenige der weiteren Trajektorien, welcher der extremale Parameter zugeordnet wird. Vorteilhaft werden nur eine Auswahl der berechneten veränderten Trajektorien, vorzugsweise die veränderten Trajektorie(n) mit den besten veränderten Parameter(n), an das Simulationsprogramm übertragen.

Das Simulationsprogramm simuliert ein Einbringen und/oder eine Entnahme des Bauteils in die Produktionsmaschine. Dabei wird anhand der Randbedingungen geprüft, ob die erste Trajektorie oder die von der Optimierungsroutine erstellte weitere Trajektorie den Randbedingungen genügt. Falls die weitere Trajektorie den Randbedingungen nicht genügt, wird die Trajektorie leicht verändert und/oder an die Optimierungsroutine mit einem entsprechenden Attribut übertragen. Falls die weitere Trajektorie den Randbedingungen genügt, wird sie zur weiteren Veränderung/Optimierung an die Optimierungsroutine übertragen. Falls die optimierte Trajektorie den Randbedingungen genügt, wird diese mit einem Attribut gespeichert und/oder in Form von Koeffizienten und/oder Funktionswerten an die Steuerungseinrichtung übertragen.

Ein Simulationsprogramm kann auch anhand von Randbedingungen eine Bahnkurve für ein Bautteil berechnen, so dass das Bauteil mit einer festgelegten Geschwindigkeit Maschine eingebracht werden kann. Das Simulationsprogramm kann Teil einer Optimierungsroutine sein. Als Randbedingungen dienen hierbei die Form und die Abmessungen des zumindest einen Bauteils, die Form und Abmessungen der Produktionsmaschine, insbesondere der Presswerkzeuge. Die Randbedingungen sorgen für eine kollisionsfreie Bestückung der Produktionsmaschine mit dem zumindest einen Bauteil

Eine Steuerungseinrichtung einer Produktionsmaschine dient zur Umwandlung der optimierten Trajektorie in eine Bewegung der Halterung zur Bestückung der zugeordneten Produktionsmaschine. Die Steuerungseinrichtung ist vorteilhaft mit einer Recheneinheit über eine technische Datenverbindung, beispielsweise eine USB-Verbindung oder eine Netzwerkverbindung, mit einer Recheneinheit verbunden, auf welcher das Simulationsprogramm und ggf. die Optimierungsroutine installiert ist.

Vorteilhaft ist eine solche Berechnungsmethode aufgrund der verbesserten Berechnung einer optimierten Trajektorie. Insbesondere falls mehrere veränderte Trajektorien miteinander verglichen werden, ist erfindungsgemäß eine extremale Trajektorie auffindbar, die selbst ein geübter Fachmann nicht auf manuellem Wege hätte finden können.

Weiter vorteilhaft ist es, dass auch zeitabhängige extremale Trajektorien durch das hier beschriebene Verfahren auffindbar sind.

Zusätzlich ist die benötigte Zeit für die Optimierung einer Trajektorie erheblich geringer.

In einer vorteilhaften Ausgestaltung weist die erste Trajektorie, die weitere Trajektorie und die optimierte Trajektorie als Komponente eine Zeit auf oder ist von der Zeit abhängig.

In diesem Dokument sind die erste Trajektorie, die weitere Trajektorie sowie die optimierte Trajektorie als Trajektorie bezeichnet, falls eine Trajektorie gemeint ist, deren Eigenschaften alle hier aufgeführten Trajektorien teilen.

Eine Trajektorie kann direkt von der Zeit abhängen. Dann ist ein Verlauf des Bauteils direkt von der Zeit abhängig. Dies ist beispielsweise der Fall, falls ein Bauteil eine Trajektorie bei einem Durchlauf in einer unterschiedlichen Zeit durchläuft wie ein Bauteil, welches entlang einer zeitlich nachfolgenden Trajektorie durchlaufen wird. Ebenso kann innerhalb eines Abschnittes der Trajektorie die Zeit, die die Halterung und/oder das Bauteil für diesen Abschnitt der Trajektorie benötigt, verschieden von der Zeit sein, welche die Halterung und/oder das Bauteil für einen gleichlangen, aber verschiedenen Abschnitt der Trajektorie benötigen. So ist es gegebenenfalls notwendig, die Geschwindigkeit des Durchlaufes der Trajektorie in einem Bereich zu verringern, in welcher die Trajektorie stark gekrümmt ist. Die Zeit kann eine absolute Zeit, eine periodisch wiederkehrende Zeitspanne oder eine Eigenzeit der Halterung sein.

Die Trajektorie kann jedoch auch von, ihrerseits zeitabhängigen, Parametern abhängen.

Die formale Darstellung der zeitlichen Abhängigkeit der Trajektorie hängt vorteilhaft von der Ausgestaltung der Optimierungsroutine und/oder vom Simulationsprogramm ab.

In einer weiteren vorteilhaften Ausgestaltung gehen als Randbedingungen die Größe und Form des Bauteils, die Größe und Form der Produktionsmaschine, die Größe und Form der Halterung und/oder eine Verformung des Bauteils und/oder der Halterung ein.

Randbedingungen dienen dem Simulationsprogramm zur Vermeidung einer Kollision der Halterung und/oder des Bauteils mit der Produktionsmaschine, insbesondere einem der Presswerkzeuge einer Presse. Falls die Produktionsmaschine bewegliche Teile aufweist, welche mit der Halterung und/oder dem Bauteil kollidieren können, sind die Randbedingungen vorteilhaft von der Zeit abhängig. Randbedingungen können auch als Einschränkungen der Bewegungen der Halterung und/oder des Bauteils und/oder der Form der Trajektorie verstanden sein. Durch die Zeitabhängigkeit der Randbedingungen ist der Raum der möglichen Trajektorien vergrößert.

In einer weiteren vorteilhaften Ausgestaltung ist die erste Trajektorie, die weitere Trajektorie und die optimierte Trajektorie eine Funktion des Ortes des Bauteils und/oder der Halterung, der Ausrichtung des Bauteils und/oder der Halterung und/oder der Zeit.

Unter der Ausrichtung der Halterung und/oder des Bauteils wird der (Raum-) Winkel verstanden, welchen das Bauteil und/oder die Halterung zur Vertikalen einnehmen. Der Ort ist der Punkt, an der ein festgelegter Punkt der Halterung und/oder das Bauteil sich im Raum befinden. Die Menge der Raumpunkte, die der festgelegte Teil der Halterung oder das Bauteil durchläuft, kann als Trajektorie definiert werden. Neben dem Ort, der Zeit und der Ausrichtung können noch weitere Abhängigkeiten wie die Durchlaufgeschwindigkeit oder die Beschleunigung des Bauteils und/oder der Halterung in die Beschreibung der Trajektorie eingehen.

Die Trajektorie kann durch eine Mannigfaltigkeit an Punkten in einem Raum oder durch Koeffizienten einer festgelegten Funktion (einer Raumkurve) angegeben sein. Vorteilhaft ist bei der Darstellung von Punkten eine besonders genaue und flexible Beschreibung der Trajektorie möglich. Demgegenüber ist bei einer Darstellung der Trajektorie durch Koeffizienten eine besonders kompakte Darstellung der Trajektorie möglich.

Besonders vorteilhaft werden die Trajektorien in beiden Darstellungen zur Verfügung gestellt. So kann eine große Anzahl an Steuerungseinrichtungen die Trajektorien aufnehmen und weiter verarbeiten, das heißt, zur Steuerung der Bestückung der Produktionsmaschine einsetzen.

In einer weiteren vorteilhaften Ausgestaltung wird die optimierte Trajektorie als Funktionswerten und/oder als Koeffizienten an eine Steuerungseinrichtung übermittelt.

Die Steuerungseinrichtung dient zur Ansteuerung der elektrischen Maschinen, wobei mit Hilfe der elektrischen Maschinen die Produktionsmaschine bestückt, beziehungsweise wieder entleert wird. Eine Steuerungseinrichtung kann beispielsweise eine Motorsteuerung zur Steuerung von mehreren, auf einander abgestimmten, Motoren sein, beispielsweise eine SIMATIC oder eine SINUMEKIK der Firma Siemens AG.

In einer weiteren vorteilhaften Ausgestaltung sind der Parameter und der veränderte Parameter zumindest eine Geschwindigkeit, wobei der extremale Wert eine maximale Geschwindigkeit ist.

Der Parameter oder der veränderte Parameter wird in der Optimierungsroutine aus einer ersten Trajektorie und/oder einer weiteren Trajektorie berechnet. Zunächst wird dafür in der, an die Optimierungsroutine zugewiesenen Trajektorie ein Parameter oder ein veränderter Parameter abgeleitet. Der Parameter wird anschließend verändert. Aus dem veränderten Parameter wird die weitere Trajektorie bestimmt oder berechnet. Der Parameter oder der veränderte Parameter ist ein Maß für den Grad der Optimierung der (weiteren) Trajektorie. Vorteilhaft nähert sich der Parameter einem extremalen Parameter oder einem vorgegebenen Parameter an. Bei Erreichen des extremalen Parameters oder des vorgegebenen Parameter durch den weiteren Parameter ist die Trajektorie, die aus dem extremalen bzw. vorgegebenen Parameter hervorgegangen ist, optimiert.

Ein (veränderter) Parameter kann eine Geschwindigkeit, eine Hubzahl oder ein minimaler Abstand des Bauteils und/oder der Halterung zur Produktionsmaschine sein. Ein extremaler Parameter kann eine maximale Geschwindigkeit sein, so dass die Halterung und/oder das Bauteil die Trajektorie in möglichst kurzer Zeit durchläuft. Der Parameter oder der veränderte Parameter kann auch eine Hubzahl, insbesondere einer Presse, oder einer Durchlaufzahl darstellen.

Bei einer besonders bedienerfreundlichen Ausgestaltung eines Computerprogrammprodukts läuft das vorstehend ausgeführte Verfahren nach Wahl zumindest einer Option, insbesondere durch Anklicken eines Buttons, selbstständig an.

Das Computerprogrammprodukt dient vorteilhaft zur Durchführung des vorstehend ausgeführten Verfahrens, wobei das Simulationsprogramm zumindest als Teil des Computerprogrammprodukts oft schon besteht. Die Optimierungsroutine kann vorteilhaft in das Simulationsprogramm integriert werden. Auf der Bedienungsoberfläche (Human-Machine-Interface) des Simulationsprogramms ist das vorstehend ausgeführte Verfahren vorteilhaft als Menüpunkt anwählbar. Bei Einbeziehung einer solchen Einbindung der Optimierungsroutine kann der Start mittels eines Knopfes (Buttons) generiert sein. Beispielsweise wird bei Anklicken eines solchen Buttons das Verfahren gestartet und läuft so lange ab, bis die Trajektorie eine optimierte Trajektorie geworden ist. Anschließend wird die optimierte Trajektorie in den vorstehend ausgeführten Formen an die Steuerungseinheit übertragen.

Im Folgenden wird die Erfindung anhand der in den Figuren dargestellten Ausführungsbeispiele näher beschrieben und erläutert. Es zeigen:
- FIG 1: eine Presse und ein Bauteil,
- FIG 2: eine Halterung mit einem Bauteil,
- FIG 3: eine Produktionsmaschine und eine Trajektorie
- FIG 4: eine Halterung mit einem Bauteil,
- FIG 5: ein Schema zur Berechnung einer optimierten Trajektorie sowie
- FIG 6: ein Schema zur Berechnung einer weiteren Trajektorie.

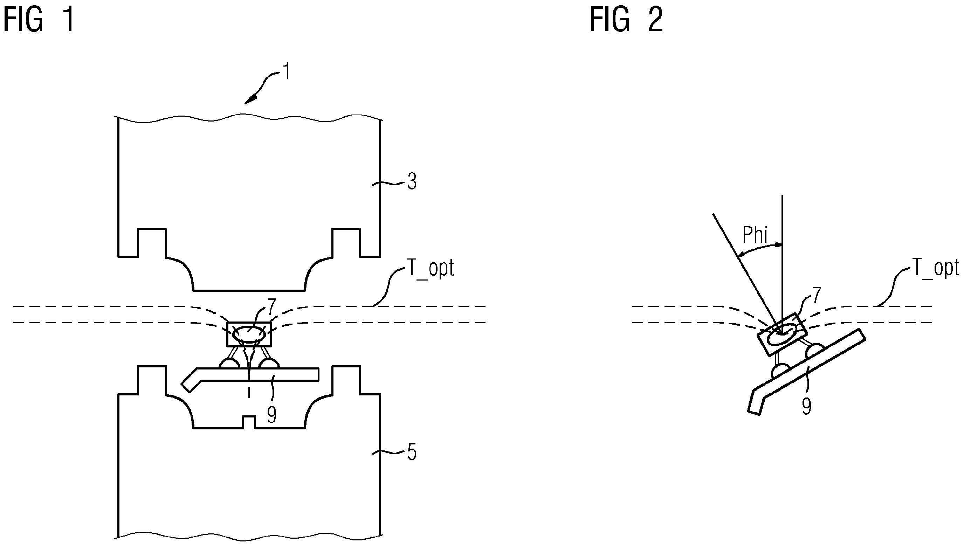

FIG 1 zeigt eine Presse 1 (oder eine andere Produktionsmaschine 1) und ein Bauteil 9. Das Bauteil 9 befindet sich zwischen dem unteren Werkzeug 5 und dem oberen Werkzeug 3. Das Bauteil 9 wird mit der Halterung 7 auf einer optimierten Trajektorie T_opt in die Presse 1, d. h. zwischen dem unteren Werkzeug 5 und dem oberen Werkzeug 3 eingebracht. In der Presse 1 wird das Bauteil 9 mit Hilfe des unteren Werkzeuges 5 und mit Hilfe des oberen Werkzeuges 3 bearbeitet. Nach der Bearbeitung des Bauteils 9 durch die Presse 1 wird das Bauteil 9 von der Halterung 7 aufgenommen und aus der Presse 1 oder der Produktionsmaschine 1 hinausbefördert. Beim Einbringen sowie beim Hinausbefördern des Bauteils 9 ist darauf zu achten, dass das Bauteil 9 nicht mit der Presse 1 unkontrolliert kollidiert. Um eine Kollision des Bauteils 9 und/oder der Halterung 7 mit der Presse 1 zu vermeiden, bewegt sich die Halterung 7 mit dem Bauteil 9 auf einer zuvor festgelegten und/oder optimierten Trajektorie T_opt.

FIG 2 zeigt eine Halterung 7 mit einem Bauteil 9. Das Bauteil 9 ist lösbar mit der Halterung 9 verbunden. Die Halterung 7 mitsamt dem Bauteil 9 verläuft auf der optimierten Trajektorie T_opt. Das Bauteil 9 und die Halterung 7 weisen die räumliche Ausrichtung Phi auf. Die räumliche Ausrichtung Phi des Bauteils 9 und/oder der Halterung 7 kann sich während des Verlaufes entlang der Trajektorie T_opt ändern. Das Bauteil 9 ist vorteilhaft lösbar mit der Halterung 7 verbunden. Das Bauteil 9 kann auch mittels der Halterung 7 in seiner Ausrichtung Phi im Vergleich zu der Ausrichtung der Halterung 7 veränderbar sein.

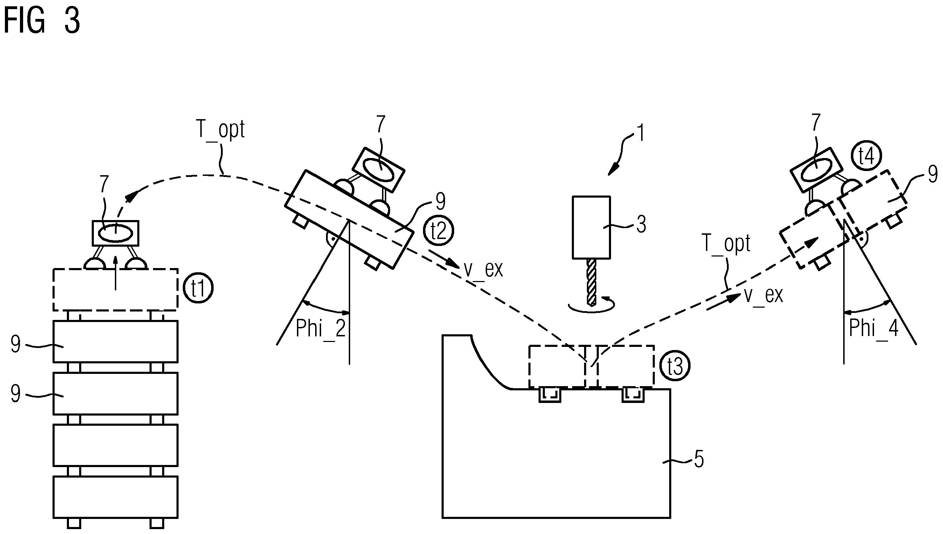

FIG 3 zeigt eine Produktionsmaschine 1 und eine Trajektorie T_opt. Zum Zeitpunkt t1 werden Bauteile 9 von der Halterung 7 aufgenommen und entlang der Trajektorie T_opt in die Produktionsmaschine 1 befördert. Das Bauteil 9 und die Halterung 7 verlaufen dabei entlang der Trajektorie T_opt. Zum Zeitpunkt t2 wird das Bauteil 9 mit Hilfe der Halterung in seiner Ausrichtung Phi_2 ausgerichtet. Zum Zeitpunkt t2 weist das Bauteil 9 und die Halterung 7 eine Geschwindigkeit v auf. Die Geschwindigkeit ist vorteilhaft eine Funktion der Zeit t und/oder der Position beziehungsweise der Ausrichtung Phi des Bauteils. Das Bauteil 9 wird von der Halterung 7 in die Produktionsmaschine 1, insbesondere in das untere Werkzeug 5 der Produktionsmaschine 1 eingelegt. In der Produktionsmaschine 1 wird das Bauteil 9 mit dem oberen Werkzeug 3 bearbeitet. Also oberes Werkzeug 3 dient hier ein Bohrer 3 oder ein Teil einer Fräsmaschine 3. Nach der Bearbeitung in der Produktionsmaschine 1 nimmt die Halterung 7 zum Zeitpunkt t3 das Bauteil 9 wieder auf und führt es entlang einer optimierten Trajektorie T_opt aus der Produktionsmaschine 1 heraus. Zum Zeitpunkt t4 ist das Bauteil 9 auf dem Weg zu einer neuen Station. Zu jedem Zeitpunkt t1, t2, t3, t4 weist das Bauteil eine Geschwindigkeit v auf. Zum Zeitpunkt t2 weist das Bauteil 9 und die Halterung 7 eine Ausrichtung Phi_2 auf. Zum Zeitpunkt t4 weist das Bauteil 9 und die Halterung 7 eine Ausrichtung Phi_4 auf. Die Geschwindigkeit v stellt dabei einen Parameter v, v' dar, welcher die Schnelligkeit der Produktion maßgeblich beeinflusst. Die Ausrichtung des Werkstückes 9 und/oder der Halterung 7 zu jedem Zeitpunkt ist durch die Ausrichtung Phi vorgegeben.

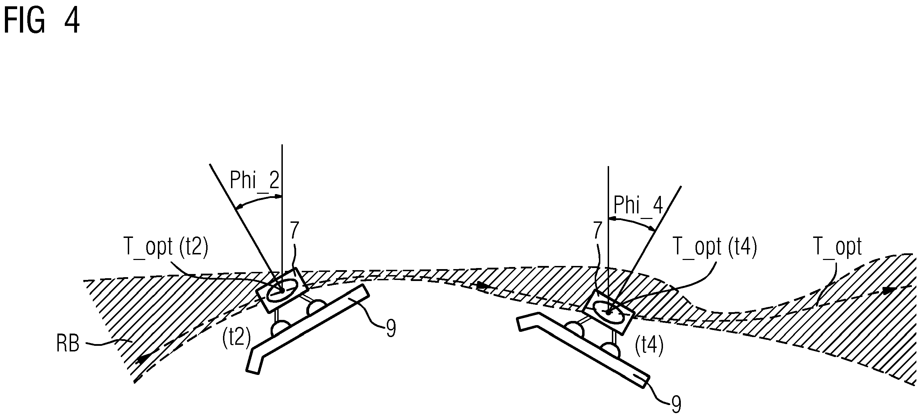

FIG 4 zeigt eine Halterung 7 und ein Bauteil 9. Das Bauteil 9 wird durch die Halterung 7 zum Zeitpunkt t2 an einem bestimmten Raumpunkt T_opt(t2) gehalten und durchläuft entlang der optimierten Trajektorie T_opt das durch die Randbedingungen RB eingeschränkte Gebiet ist durch die Schraffierung angedeutet. Zwischen den gestrichelten Linien kann die Trajektorie T, T_opt verlaufen. Die Figur zeigt die Halterung 7 und das Bauteil 9 zum Zeitpunkt t2 mit einer Ausrichtung Phi_2 und zu einem weiteren Zeitpunkt t4 mit einer anderen Ausrichtung Phi_4. In dieser Skizze ist das Bauteil 9 fest und starr mit der Halterung 7 verbunden. Es ist auch möglich, dass die Ausrichtung Phi des Bauteils 9 zumindest teilweise durch die Halterung 7 mitbestimmt wird, d.h., dass die Halterung 7 zu einem Zeitpunkt t2, t4 eine Ausrichtung Phi_2, Phi_4 aufweist und das Bauteil 9 eine andere Ausrichtung Phi im Raum einnimmt, wobei die Ausrichtung Phi der Halterung 7 und die sich bei einer starren Halterung 7 des Bauteils 9 durch die Halterung 7 von der gemeinsam vorliegenden Ausrichtung Phi zu den Zeitpunkten t₁ und t₂ unterscheidet.

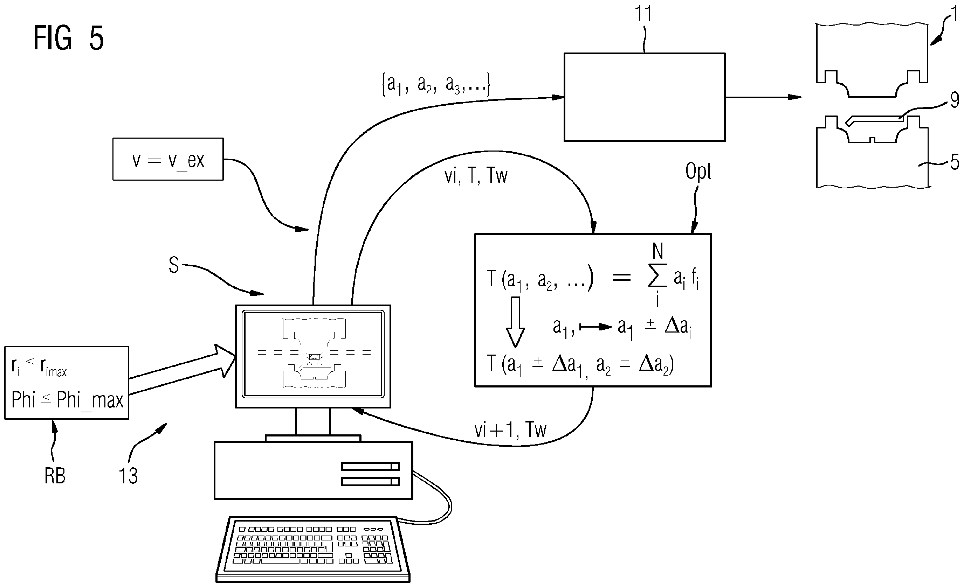

FIG 5 zeigt ein Schema zur Berechnung einer optimierten Trajektorie T_opt. Gezeigt ist eine Recheneinheit 13, beispielsweise ein Personal Computer 13, auf dem das Simulationsprogramm S installiert ist und abläuft. Die Berechnung der optimierten Trajektorie T_opt erfolgt mit Hilfe des Simulationsprogramms S und/oder der Optimierungsroutine Opt. Weiter ist auch die Optimierungsroutine Opt auf der Recheneinheit 13 installiert. Obgleich die Optimierungsroutine Opt Teil des Simulationsprogramm S sein kann, ist die Optimierungsroutine Opt getrennt von dem Simulationsprogramm S dargestellt. Das Verfahren startet mit Vorgabe einer ersten Trajektorie T1, beispielsweise händisch durch einen Benutzer. Die erste Trajektorie T1 kann auch durch Vorgaben des Benutzers mit dem Simulationsprogramm S erstellt worden sein. Weiter sind Randbedingungen RB vorgegeben, wobei auch die Randbedingungen RB vorteilhaft aus CAD-Zeichnungen der Produktionsmaschine 1, des zumindest einen Bauteils 9 sowie gegebenenfalls weiterer Größen mittels des Simulationsprogramms S ermittelt worden sein können. Bei einem ersten Durchlauf des Verfahrens erfolgt die Ermittlung eines Parameters v, hier vorteilhaft durch das Simulationsprogramm S. Es ist auch möglich, den Parameter v mit Hilfe der Optimierungsroutine Opt zu bestimmen. Nach Berechnung der (ersten) Trajektorie T1 wird die (erste) Trajektorie T1 und gegebenenfalls der Parameter v oder der weiteren Parameter vi an die Optimierungsroutine Opt übermittelt. In der Optimierungsroutine Opt wird in einer vorteilhaften Weise eine Darstellung der Trajektorie T(a1, a2, ...) bereitgestellt, beispielsweise einer Reihendarstellung. Die Koeffizienten ai, i=1,...,N der Reihendarstellung der Trajektorie T(a₁,a₂,...) werden in einem weiteren Schritt gemäß einem deterministischen oder propabilistischen Schema verändert. Beispielsweise werden die einzelnen Koeffizienten a₁ vergrößert aᵢ+Δaᵢ oder verkleinert aᵢ-Δaᵢ. Aus den so veränderten Koeffizienten aᵢ±Δaᵢ wird eine veränderte Trajektorie T(a₁±Δa₁, a₂+Δa₂,...) erstellt. Vorteilhaft wird die veränderte Trajektorie T (a₁+Δa₁, a₂±Δa₂,...) wieder auf die erste Trajektorie T(a₁,a₂,...) normiert.

Die veränderte Trajektorie Tw = T(a₁±Δa₁, a₂±Δa₂,...) wird dann an das Simulationsprogramm S übertragen. Das Simulationsprogramm richtet die veränderte/weitere Trajektorie Tw so, dass die Randbedingungen RB eingehalten werden. Vorteilhaft ist das Simulationsprogramm S in der Lage, die weitere Trajektorie Tw anhand ihrer neuen Eigenschaften mit der vorangehenden Trajektorie T zu vergleichen. Als Vergleichsmaßstab dient beispielsweise der Parameter vi, vi+1, v, v'. Ist der Parameter vi, vi+1, v, v' beispielsweise die Geschwindigkeit vi, vi+1, v, v', mit der das Bauteil 9 in die Produktionsmaschine 1 eingeführt und/oder wieder entnommen ist, so ist die Veränderung der Trajektorie T, Tw als ein Schritt in die richtige Richtung, hin zur Form der optimierten Trajektorie T_opt zu werten.

Die vorstehend beschriebene Schleife wird so lange durchlaufen, bis die Änderungen Δai des veränderten Parameters vi, vi+1 nach Durchlauf der Schleifen unter einen vorgegebenen Wert fallen oder sobald der veränderte Parameter einen vorgegebenen Bereich unterschreitet. Die Trajektorie T und die weitere Trajektorie kann zwischen dem Simulationsprogramm S und der Optimierungsroutine Opt in Form von Parametern v, v+1, als Trajektorien T, Tw und/oder in der Form von Koeffizienten a1, a2,... übertragen werden.

Die im letzten Durchlauf der Schleife erhaltene optimierte Trajektorie T_opt wird bei Erreichen des extremalen Parameters v_ex in Form von Koeffizienten a₁,a₂,... an die Steuerungseinrichtung 11 übermittelt. Die Steuerungseinrichtung 11 steuert die Bestückung der Produktionsmaschine 1 mit Bauteilen, insbesondere durch die Steuerung 11 der durchlaufenen optimierten Trajektorie T_opt der Halterung 7 für das Bauteil 9.

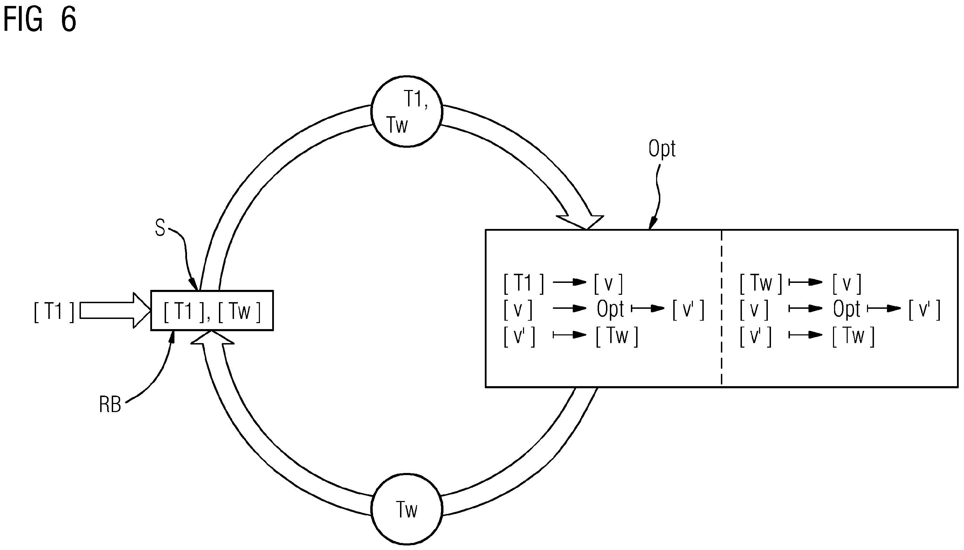

FIG 6 zeigt ein Schema zur Berechnung einer weiteren Trajektorie Tw. Insbesondere ist hier ein Schema des ersten Durchganges der Schleife zur Berechnung der optimierten Trajektorie T1 offenbart. Ausgehend von einer ersten Trajektorie T1 wird mit Hilfe des Simulationsprogrammes S sichergestellt, ob die erste Trajektorie T1 die Randbedingungen RB erfüllt. Falls die Randbedingungen RB durch die erste Trajektorie T1 nicht erfüllt sind, wird die erste Trajektorie T1 mit Hilfe des Simulationsprogramms S angepasst. Die erste Trajektorie T1 wird dann an die Optimierungsroutine Opt übermittelt. Mit Hilfe der Optimierungsroutine wird ein Parameter v aus der ersten Trajektorie T1 (und/oder einer weiteren Trajektorie Tw) ermittelt. Der Parameter v wird mit Hilfe der Optimierungsroutine Opt in einen veränderten Parameter v' verändert. Mit Hilfe des veränderten Parameters v' wird eine weitere Trajektorie Tw erzeugt. Die weitere Trajektorie Tw wird an das Simulationsprogramm S übertragen. Mit Hilfe des Simulationsprograms S wird die weitere Trajektorie an die Randbedingungen RB angepasst. Nach erfolgter Anpassung der weiteren Trajektorie Tw wird diese wieder an die Optimierungsroutine übertragen wobei mit der Optimierungsroutine Opt in der weiteren Trajektorie Tw ein Parameter v erzeugt. Der Parameter v wird mit Hilfe der Optimierungsroutine Opt in einen veränderten Parameter v' überführt. Mit Hilfe zumindest des veränderten Parameters v' wird eine weitere Trajektorie Tw erstellt.

Bei der Erstellung der weiteren Trajektorie Tw und/oder des veränderten Parameters v' können auch (veränderte) Parameter v, v' und/oder schon erzeugte und gegebenenfalls gespeicherte (weitere) Trajektorien T1, Tw berücksichtigt werden.

Sobald der veränderte Parameter v' einen bestimmten Wert v_ex oder bestimmte Werte v_ex erreicht habt, so kann wird aus der weiteren Trajektorie Tw die optimierte Trajektorie T_opt. Diese wird gegebenenfalls noch einmal an den Randbedingungen RB überprüft. Die optimierte Trajektorie wird dann für die Steuerungseinrichtung 11 Produktionsmaschine 1 bereitgestellt.

Das vorgestellte Verfahren ist insbesondere zur Durchführung einer sogenannten Press-Line-Simulation vorteilhaft einsetzbar.

Mittels des Simulationsprogramms erfolgt dabei eine Darstellung eines Simulationsszenarios. Beispiele für ein Simulationsszenario ist die Einrichtung einer Presse 1 oder einer Produktionsmaschine 1 oder einer Kollisionsanalyse. Die Veränderung der Parameter v, v' erfolgt vorteilhaft unter Berücksichtigung einer Transferkurve (Trajektorie T, weitere Trajektorie Tw, oder optimierte Trajektorie T_opt).

Resultate eines hier vorgestellten Verfahrens sind beispielsweise ein Kollisionsbericht, eine Stückliste der mit der Halterung 7 zu transportierenden Bauteile 9, eine Liste der Programmierwerte und/oder ein Simulationsvideo bzw. eine Bildabfolge.

Das Verfahren zur Berechnung einer optimierten Trajektorie erfolgt vorteilhaft in zwei Schritten:
- Zum einen eine Änderung von Größen wie die Trajektorie T, Tw, T_opt, bis keine Kollision des Bauteils 9 und/oder der Halterung mehr mit einem weiteren Element, insbesondere der Produktionsmaschine 1 und/oder der Presse 1 mehr auftritt.
- Zum anderen in einer Optimierung der Geschwindigkeit v, v', v_ex des Bauteils 9 entlang einer solchen Trajektorie T, Tw, insbesondere einer optimierten Trajektorie T_opt und/oder einer Optimierung der Hubzahl v, v', v_ex einer Presse 1 oder der Produktionsmaschine 1.

Als Basis eines Optimierungsverfahrens dient vorteilhaft ein so genannter Solver. Ein Solver ist vorzugsweise eine O-penSource Software, die einen allgemeinen Optimierungsalgorithmus enthält und für den jeweiligen Fall angepasst werden kann. Eine solche Anpassung erfolgt vorteilhaft in Angabe von Parameter aller Art, Werten, die den Solver beeinflussen, sowie durch Hinzufügen von eigenen Programmcodes zu dieser Solver-Software. Ein Hinzufügen kann auch in einem so genannten Software-Add-On erfolgen.

Trajektorien T, T1, Tw, T_opt werden oft auch als Transferkurven oder Transportkurven bezeichnet. Diese werden während der Simulation mit Hilfe des Simulationsprogramms S laufend angepasst, ggf. mit Hilfe einer hier vorgestellten Optimierungsroutine Opt, bis ein Optimum erreicht ist. Vorteilhaft kann ein hier beschriebenes Verfahren nach Errichtung der Produktionsanlage, die eine Produktionsmaschine 1 aufweist, erfolgen. Im Betrieb der Produktionsanlage erfolgt danach nur noch ein leichtes Abstimmen der optimierten Trajektorie.

Vorteilhafte Größen für die Parameter bzw. für die Randbedingungen sind einzuhaltende Abstandswerte zwischen Bauteil 9 / Halterung 7 und den weiteren Elementen (wie der Produktionsmaschine 1). Weitere Parameter orientieren sich auch vorteilhaft an der Ausrichtung (Drehwerte) des Bauteils 9, Anfangszeitpunkte ti, t und/oder Endzeitpunkte ti, t des Bauteils 9 und/oder der Halterung 7 während des Durchlaufs entlang der (optimierten) Trajektorie T, Tw, T_opt.

Vorteilhaft findet auch eine Variation der Anzahl der so genannten Stützpunkte der (optimierten) Trajektorie T, T_opt, Tw statt. Stützpunkte sind Raumpunkte, die die (optimierte) Trajektorie T, T1, Tw, T_opt definieren/aufspannen.

Zusammenfassend betrifft die Erfindung ein Verfahren zur Berechnung einer optimierten Trajektorie T_opt mit Hilfe eines Simulationsprogramms S und einer Optimierungsroutine Opt. Während des Verfahrens wird die Trajektorie T, T1, Tw mit Hilfe eines Simulationsprogramms bereitgestellt und an Randbedingungen RB angepasst. Das Verfahren weist eine Schleife auf, wobei die Schleife
- die Bereitstellung einer ersten Trajektorie T1,
- die Modifikation der (weiteren) Trajektorie T1, Tw,
- sowie die Anpassung der (weiteren) Trajektorie T1, Tw,T anhand von Randbedingungen RB
als einzelne Schritte aufweist. Die optimierte Trajektorie T_opt ist eine Trajektorie T, Tw, welche anhand eines extremalen oder vorbestimmten Parameter v', v_ex bereitgestellt worden ist. Die optimierte Trajektorie T_opt wird nach der Berechnung einer Steuerungseinrichtung 11 zur Bewegung einer Halterung 7 für ein Bauteil 9 bereitgestellt.

## Patentansprüche

1. Verfahren zur Berechnung einer optimierten Trajektorie (T_opt) mindestens eines Bauteils (9) und/oder einer Halterung (7) für das Bauteil (9) für einen Transport des Bauteils (9) in eine Produktionsmaschine (1) hinein und/oder aus der Produktionsmaschine (1) heraus, wobei mindestens eine Optimierungsroutine (Opt) einem Simulationsprogramm (S) zugeordnet ist, wobei das Simulationsprogramm das Einbringen und/oder die Entnahme des Bauteils aus der Produktionsmaschine simuliert, wobei mit dem Simulationsprogramm (S) anhand von Randbedingungen (RB) eine erste Trajektorie (T1) berechnet wird, in der Optimierungsroutine (Opt) aus der ersten Trajektorie (T1) ein Parameter (v), insbesondere eine Geschwindigkeit (v), berechnet wird, wobei mittels der Optimierungsroutine (Opt) ein veränderter Parameter (v') ermittelt wird und zumindest eine weitere Trajektorie (Tw) anhand dem veränderten Parameter (v') erzeugt wird, wobei die weitere Trajektorie (Tw) in einer Schleife verändert wird, wobei die Schleife zumindest folgende Schritte aufweist:
- wobei in einem Schritt mittels des Simulationsprogramms (S) die weitere Trajektorie (Tw) an die Randbedingungen (RB) angepasst wird und der Optimierungsroutine (Opt) zugewiesen wird,
- wobei in einem Schritt auf Grundlage der weiteren Trajektorie (Tw) der Parameter (v) ermittelt wird,
- wobei in einem Schritt auf Grundlage des Parameters (v) der veränderte Parameter (v') ermittelt wird,
- wobei in einem Schritt auf Grundlage des veränderten Parameters (v') die weitere Trajektorie (Tw) berechnet wird und die weitere Trajektorie (Tw) dem Simulationsprogramm (S) zugewiesen wird,
wobei die Schleife so lange durchlaufen wird, bis der veränderte Parameter (v') einen vorgegebenen Wert (v_ex) oder einen extremalen Wert (v_ex) erreicht, wobei die optimierte Trajektorie (T_opt) aus dem extremalen Wert (v_ex) oder dem vorgegebenen Wert (v_ex) berechnet und mit dem Simulationsprogramm (S) an die Randbedingungen (RB) angepasst wird.

2. Verfahren nach Anspruch 1, wobei die erste Trajektorie (T1), die weitere Trajektorie (Tw) und die optimierte Trajektorie (T_opt) als Komponente eine Zeit (t) aufweist oder von der Zeit (t) abhängt.

3. Verfahren nach einem der vorangehenden Ansprüchen, wobei als Randbedingungen (RB) die Größe und Form des Bauteils (9), die Größe und Form der Produktionsmaschine (1), die Größe und Form der Halterung (7) und/oder eine Verformung des Bauteils (9) und/oder der Halterung (7) eingehen.

4. Verfahren nach einem der vorangehenden Ansprüche, wobei die erste Trajektorie (T1), die weitere Trajektorie (Tw) und die optimierte Trajektorie (T_opt) eine Funktion des Ortes (r) des Bauteils (9) und/oder der Halterung (7), der Ausrichtung (Phi) des Bauteils (9) und/oder der Halterung (9) und/oder der Zeit (t) ist.

5. Verfahren nach einem der vorangehenden Ansprüche, wobei die optimierte Trajektorie (T_opt) in Funktionswerten (r_i, t_i, Phi_i, f_1) und/oder in Koeffizienten (a_i) überführt wird.

6. Verfahren nach einem der vorangehenden Ansprüche, wobei die optimierte Trajektorie (f_opt) als Funktionswerten (r_i, t_i, Phi_i, f_1) und/oder als Koeffizienten (a_i) an eine Steuerungseinrichtung (11) übermittelt wird.

7. Verfahren nach einem der vorangehenden Ansprüche, wobei der Parameter (v) und der veränderte Parameter (v') Geschwindigkeiten (v, v') sind und wobei der extremale Wert (v_ex) eine maximale Geschwindigkeit (v_ex) ist.

8. Computerprogrammprodukt laufend auf einem Rechnersystem, aufweisend ein Simulationsprogramm (S), wobei das Simulationsprogramm (S) und eine Optimierungsroutine (Opt) zur Durchführung eines Verfahrens gemäß einem der vorangehenden Ansprüche vorgesehen ist, wenn das Computerprogrammprodukt auf einen Computer geladen und ausgeführt wird, wobei das Verfahren gemäß einem der Ansprüche 1 bis 7 nach Wahl zumindest einer Option selbstständig anläuft.

9. Steuerungseinrichtung (11) einer Produktionsmaschine (1) zur Durchführung eines Verfahrens nach einem der Ansprüche 1 bis 7.

10. Produktionsmaschine (1) aufweisend eine Steuerungseinrichtung (11) gemäß Anspruch 9.

## Claims

1. Method for calculating an optimised trajectory (T_opt) of at least one component part (9) and/or one holder (7) for the component part (9) for transporting the component part (9) into a production machine (1) and/or out of the production machine (1), wherein at least one optimisation routine (Opt) is assigned to a simulation program (S), wherein the simulation program simulates the insertion into and/or the removal from the production machine of the component part, wherein a first trajectory (T1) is calculated using the simulation program (S) on the basis of marginal conditions (RB), in the optimisation routine (Opt) a parameter (v), in particular a velocity (v), is calculated from the first trajectory (T1), wherein a modified parameter (v') is ascertained by means of the optimisation routine (Opt) and at least one further trajectory (Tw) is created on the basis of the modified parameter (v'), wherein the further trajectory (Tw) is modified in a loop, wherein the loop comprises at least the following steps:
- wherein in one step the further trajectory (Tw) is adjusted to the marginal conditions (RB) by means of the simulation program (S) and is assigned to the optimisation routine (Opt),
- wherein in one step the parameter (v) is ascertained on the basis of the further trajectory (Tw),
- wherein in one step the modified parameter (v') is ascertained on the basis of the parameter (v),
- wherein in one step the further trajectory (Tw) is calculated on the basis of the modified parameter (v') and the further trajectory (Tw) is assigned to the simulation program (S),
wherein the loop is executed until such time as the modified parameter (v') reaches a predefined value (v_ex) or an extremal value (v_ex), wherein the optimised trajectory (T_opt) is calculated from the extremal value (v_ex) or the predefined value (v_ex) and is adjusted to the marginal conditions (RB) by means of the simulation program (S).

2. Method according to claim 1, wherein the first trajectory (T1), the further trajectory (Tw) and the optimised trajectory (T_opt) has a time (t) as a component or is dependent on the time (t).

3. Method according to one of the preceding claims, wherein the size and shape of the component part (9), the size and shape of the production machine (1), the size and shape of the holder (7) and/or a deformation of the component part (9) and/or of the holder (7) are considered as marginal conditions (RB) .

4. Method according to one of the preceding claims, wherein the first trajectory (T1), the further trajectory (Tw) and the optimised trajectory (T_opt) is a function of the location (r) of the component part (9) and/or the holder (7), of the orientation (Phi) of the component part (9) and/or the holder (9) and/or of the time (t).

5. Method according to one of the preceding claims, wherein the optimised trajectory (T_opt) is conveyed in function values (r_i, t_i, Phi_i, f_1) and/or in coefficients (a_i).

6. Method according to one of the preceding claims, wherein the optimised trajectory (f_opt) is conveyed as function values (r_i, t_i, Phi_i, f_1) and/or as coefficients (a_i) to a control device (11).

7. Method according to one of the preceding claims, wherein the parameter (v) and the modified parameter (v') are velocities (v, v') and wherein the extremal value (v_ex) is a maximum velocity (v_ex).

8. Computer program product running on a computer system, having a simulation program (S), wherein the simulation program (S) and an optimisation routine (Opt) are provided for executing a method according to one of the preceding claims when the computer program package is loaded and executed on a computer, wherein the method according to one of claims 1 to 7 starts autonomously after at least one option is chosen.

9. Control device (11) of a production machine (1) for executing a method according to one of claims 1 to 7.

10. Production machine (1) having a control device (11) according to claim 9.

## Revendications

1. Procédé de calcul d'une trajectoire optimisée (T_opt) d'au moins une pièce (9) et/ou d'un support (7) de la pièce (9) pour un transport de la pièce (9) jusque dans une machine de production (1) et/ou hors de la machine de production (1), dans lequel au moins une routine d'optimisation (Opt) est affectée à un programme de simulation (S), le programme de simulation simule l'introduction dans et/ou le prélèvement de la pièce hors de la machine de production, dans lequel une première trajectoire (T1) est calculée au moyen du programme de simulation (S) en se basant sur des conditions limites (RB), un paramètre (v), notamment une vitesse (v) est calculé dans la routine d'optimisation (Opt) à partir de la première trajectoire, un paramètre modifié (v') est déterminé au moyen de la routine d'optimisation (Opt) et au moins une trajectoire supplémentaire (Tw) est produite sur la base du paramètre modifié (v'), et la trajectoire supplémentaire (Tw) est modifiée dans une boucle, dans lequel la boucle comprend au moins les étapes suivantes dans lesquelles :
- dans une étape, au moyen du programme de simulation (S), la trajectoire supplémentaire (Tw) est adaptée aux conditions limites (RB) et affectée à la routine d'optimisation (Opt),
- dans une étape, le paramètre (v) est déterminé sur la base de la trajectoire supplémentaire (Tw),
- dans une étape, le paramètre modifié (v') est déterminé sur la base du paramètre (v), et
- dans une étape, la trajectoire supplémentaire (Tw) est calculée sur la base du paramètre modifié (v') et la trajectoire supplémentaire (Tw) est affectée au programme de simulation (S),
dans lequel la boucle est exécutée jusqu'à ce que le paramètre modifié (v') atteigne une valeur prédéfinie (v_ex) ou une valeur extrême (v_ex), et la trajectoire optimisée (T_opt) est calculée à partir de la valeur extrême (v_ex) ou de la valeur prédéfinie (v_ex) et adaptée aux conditions limites (RB) au moyen du programme de simulation (S).

2. Procédé selon la revendication 1, dans lequel la première trajectoire (T1), la trajectoire supplémentaire (Tw) et la trajectoire optimisée (T_opt) comprennent un temps (t) en tant que composante ou sont fonction du temps (t).

3. Procédé selon l'une des revendications précédentes, dans lequel les conditions limites (RB) incluent la grandeur et la forme de la pièce (9), la grandeur et la forme de la machine de production (1), la grandeur et la forme du support (7) et/ou une déformation de la pièce (9) et/ou du support (7).

4. Procédé selon l'une des revendications précédentes, dans lequel la première trajectoire (T1), la trajectoire supplémentaire (Tw) et la trajectoire optimisée (T_opt) sont une fonction de l'emplacement (r) de la pièce (9) et/ou du support (7), de l'orientation (Phi) de la pièce (9) et/ou du support (9) et/ou du temps (t).

5. Procédé selon l'une des revendications précédentes, dans lequel la trajectoire optimisée (T_opt) est transformée en des valeurs de fonction (r_i, t_i, Phi_i, f_1) et/ou en des coefficients (a_i).

6. Procédé selon l'une des revendications précédentes, dans lequel la trajectoire optimisée (f_opt) est transmise sous forme de valeurs de fonction (r_i, t_i, Phi_i, f_1) et/ou sous forme de coefficients (a_i) à un dispositif de commande (11).

7. Procédé selon l'une des revendications précédentes, dans lequel le paramètre (v) et le paramètre modifié (v') sont des vitesses (v, v') et dans lequel la valeur extrême (v_ex) est une vitesse maximale (v_ex).

8. Produit de programme informatique exécutable sur un système informatique, comprenant un programme de simulation (S), dans lequel, lorsque le produit de programme informatique est chargé et exécuté sur un ordinateur, le programme de simulation (S) et une routine d'optimisation (Opt) sont configurés pour exécuter un procédé selon l'une des revendications précédentes, dans lequel le procédé selon l'une des revendications 1 à 7 démarre automatiquement selon une sélection d'au moins une option.

9. Dispositif de commande (11) d'une machine de production (1) permettant d'exécuter un procédé selon l'une des revendications 1 à 7.

10. Machine de production (1) comprenant un dispositif de commande (11) selon la revendication 9.
